# EUROPEAN PATENT SPECIFICATION

(11) **EP 2 198 630 B1**
(45) Date of publication and mention of the grant of the patent: **13.06.2012**
(21) Application number: 08830794.7
(22) Date of filing: 11.09.2008
(51) Int. Cl.: H04R 9/06

(54) **PCB WITH EMBEDDED SPEAKER ASSEMBLY**
PCB MIT EINGEBETTETER LAUTSPRECHERANORDNUNG
CARTE DE CIRCUITS IMPRIMES A ENSEMBLE DE HAUT-PARLEURS INTEGRE

(30) Priority: 14.09.2007 US 855275
(43) Date of publication of application: 23.06.2010
(73) Proprietor: Sony Ericsson Mobile Communications AB, 221 88 Lund (SE)
(72) Inventor: EATON, William, Chris, Cary NC 27519 (US); MARCINKIEWICZ, Walter, M., Chapel Hill NC 27517 (US)
(74) Representative: HOFFMANN EITLE
(86) International application number: PCT/US2008/075954
(87) International publication number: WO 2009/036124

(56) References cited:
- WO-A-00/27166
- WO-A-00/32013
- WO-A-85/03613
- US-A- 4 641 345
- US-A- 5 481 618
- US-A- 5 949 895

## Description

### BACKGROUND OF THE INVENTION

The present invention is related to speakers in electronic devices, and more specifically to a printed circuit board (PCB) with an embedded speaker assembly.

As volume in electronic devices is occupied principally by a display, a battery, and other components, the need for the size/thickness for acoustic components to shrink is high. Electronic components such as cell phones, personal digital assistants (PDAs), laptop computers, portable audio players (e.g., MP3 players), portable video players, etc. are continually being made smaller and smaller, thus minimizing the available space for electronic components and other components such as speaker systems. Current speaker systems take up valuable space in these electronic components. Further, in devices that require a telecoil (T-coil) to support hearing aid devices, additional space is need for the T-coil as well the coil that is a part of the speaker system.
WO 00/27166 A2 relates to transducer concepts for hearing aids and other devices. The loudspeaker can be housed within a hearing aid housing.
WO 85/03613 A1 relates to a circuit board assembly, a handset and a method of producing a circuit board assembly for a handset. The handset comprises two housing parts and a circuit board assembly including substantially all electronic components of the handset comprising a first transducer or microphone. The transducer comprises a transducer foil, i.e. a piezoelectric sheet having metallic layers.
WO 00/32013 A1 relates to an electric-acoustic transducer having moving magnets and transducing method thereof. The electric-acoustic transducer comprises at least one fixed coil adapted to generate alternating magnetic field upon externally receiving an electrical drive signal, a frame having a recessed structure for centrally receiving and supporting the fixed coil, at least one moving permanent magnet disposed over the fixed coil and a vibrating diaphragm.
US 5,481,618 relates to an interconnection of a speaker using magnetic coupling. A speaker assembly includes the speaker having at least one speaker terminal and a magnet which generates a magnetic field. The speaker assembly also includes a circuit board having at least one terminal. A metal member is coupled to the circuit board and is used to magnetically attach the speaker to the circuit board.
Us 5,949,895 relates to a disposable audio processor for use with implanted hearing devices. The audio processor may include a microphone, application specific integrated circuit performing both signal processing and signal modulation, a battery, and a coil.
US 4,641,345 relates to a body-sensible acoustic device. The device can be readily mounted on and detached from a seat of an automobile. A drive unit driven by acousto-electrical signals is mounted on a vibration transmitting member.
US 5,446,797 relates to an audio transducer with etched voice coil. The transducer has a voice coil formed by an etched, flexible circuit having an elongated, oblong spiral loop and rolled into a cylindrical tube. The coil cooperates with a magnetic structure including a circular, central magnet having a front north pole plate and rear south pole plate sized to fit closely within the cylindrical coil. Conventional printed circuit manufacturing techniques may be used for manufacturing the pattern of the coil.

### BRIEF SUMMARY OF THE INVENTION

The invention aims at providing a compact Speaker system and electronic device.
This is achieved by the independent claim. Advantageous embodiments are described in the dependent claims.
Embodiments of the present invention are related to an electronic device that includes a printed circuit board (PCB), and a speaker assembly, the speaker assembly comprising a coil being embedded in the PCB.

Embodiments of the present invention are further related to a speaker system that includes a printed circuit board (PCB), and a speaker assembly, the speaker assembly comprising a coil being embedded in the PCB.

Embodiments of the present invention are still further related to an electronic device that includes a printed circuit board (PCB), the PCB including one of a cavity or through hole, and a speaker assembly, the speaker assembly comprising at least a magnet and a coil, wherein at least the magnet is at least partially located in the cavity or through hole of the PCB.

### BRIEF DESCRIPTION OF THE DRAWINGS

The present invention is further described in the detailed description which follows in reference to the noted plurality of drawings by way of nonlimiting examples of embodiments of the present invention in which like reference numerals represent similar parts throughout the several views of the drawings and wherein:

Figure 1 is a speaker system according to an example embodiment of the present invention;

Figure 2 is a diagram of a cutout top/bottom view of a speaker system according to an example embodiment of the present invention;

Figure 3 is a diagram of a speaker system according to a another embodiment of the present invention; and

Figure 4 is a diagram of a speaker system according to a still further embodiment of the present invention.

### DETAILED DESCRIPTION OF THE INVENTION

According to embodiments of the present invention a speaker assembly is embedded in a printed circuit board (PCB). The speaker assembly is placed in the PCB and preferably be no more than the thickness of the PCB (e.g., 1mm thick). The thickness of the diaphragm of the speaker assembly may be approximately 10mm. Embedded speaker assemblies according to embodiments of the present invention may be applied to either an earphone speaker or a loudspeaker. Further, a coil in the speaker system may be used as a T-coil for hearing aid compatibility.

In embodiments of the present invention, a speaker assembly is formed using a coil embedded in the PCB material. A diaphragm/magnet assembly may be placed into the PCB through a hole or cavity in the PCB and soldered or glued into place at the edges or a surface of the diaphragm of the speaker assembly. Further, for a loudspeaker, a shield may be used as an additional sealed or nearly sealed box to lower the resonance frequency and decrease distortion.

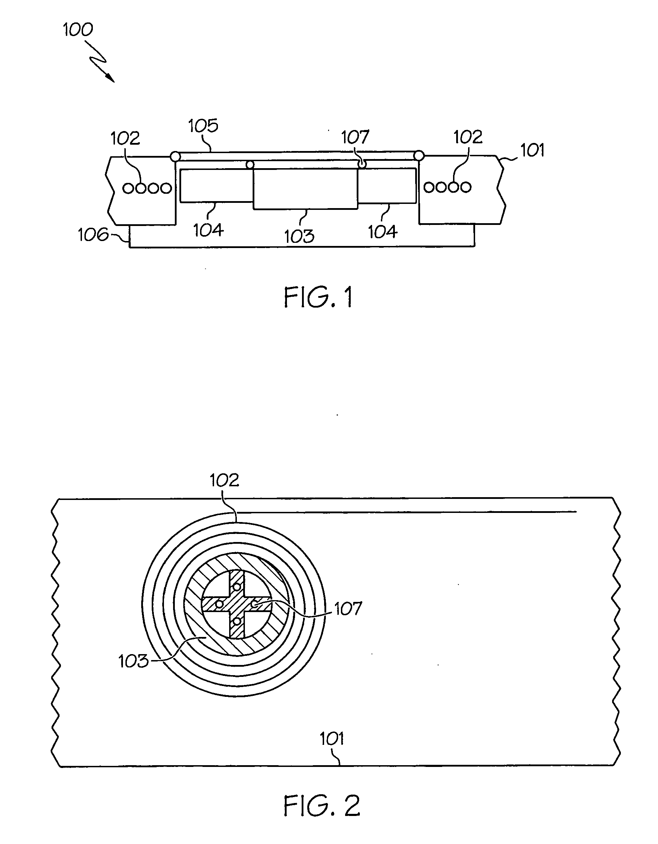

Figure 1 shows a speaker system according to an example embodiment of the present invention. The speaker system 100 includes a printed circuit board 101 that includes an embedded speaker assembly. The speaker assembly includes a coil 102 embedded in the printed circuit board 101, a magnet 103 at least partially located in a through hole of the printed circuit board 101 and located in an open center portion of windings of the coil 102, and a diaphragm 105 connected to a surface of the printed circuit board 101. The magnet 103 may be interconnected to one or more magnet holders 104 that are connected to the diaphragm 105 via one or more attachment devices 107. The speaker assembly may also include a shield can 106 that may be used to decrease resonant frequency of the acoustic system and distortion caused by electromagnetic fields being received or transmitted from electrical components. The magnet holders 104 may be made of any type material appropriate for holding a magnet and attaching it to the diaphragm 105, for example a rigid plastic material. Further, the coil 102 may be built into the printed circuit board 101 when the printed circuit board is manufactured where the manufactured printed circuit board 101 is manufactured with built-in connection points to the coil 102 for connecting electrical circuits to the coil 102.

The speaker assembly that includes the magnet 103, the magnet holders 104, the attachment devices 107, the coil 102, and the diaphragm 105, is at least partially embedded in the printed circuit board 101 such that the speaker assembly requires little to no additional space and may be the same or less than the thickness of the printed circuit board 101. This is advantageous for devices that have a need for a speaker assembly and may have space and size requirements.

Moreover, in embodiments according to the present invention, the embedded coil 102 may also serve as a telecoil (T-coil) that may be used to interface with hearing aid devices. When a T-coil is placed in an electromagnetic field, an electrical signal is produced that is received by the hearing aid device and amplified. Since the coil 102 embedded in the printed circuit board 101 may be used as a T-coil, no separate additional coil is required to serve this function. Further, should smaller sizes be desired, embodiments of the present invention are flexible in that the size of the speaker assembly components/materials and the coil may be adjusted as well as the speaker assembly surface area to get the desired properties from the speaker system while the speaker assembly is embedded in a thinner printed circuit board.

A speaker assembly according to example embodiments of the present invention may be used in any type of electronic device that uses a speaker. For example, the speaker assembly according to embodiments of the present invention may be used in mobile phones, personal digital assistants (PDAs), computers, electronic game devices, electronic audio devices, electronic video devices, etc.

Figure 2 shows a diagram of a cutout top/bottom view of a speaker system according to an example embodiment of the present invention. In this perspective, a cutout of the top (or bottom depending on the placement of the diaphragm) view of the printed circuit board 101 is shown. To help illustrate the present invention, the diaphragm 105 is not shown. However, the attachment devices 107 on the magnet holder devices 104 are shown illustrating where the diaphragm 105 may be attached. The windings of the coil 102 are shown as a series of interconnected non-uniform circles where in this example embodiment, the coil consists of four winding turns. Although four turns are shown as an example, embodiments of the present invention are not limited or restricted to coil windings of four turns but may include a coil with any practical number of turns and still be within the scope of the present invention. The diagram in Figure 2 shows a spoke configuration for the magnet holders 104, however, any magnet holder configuration may be used.

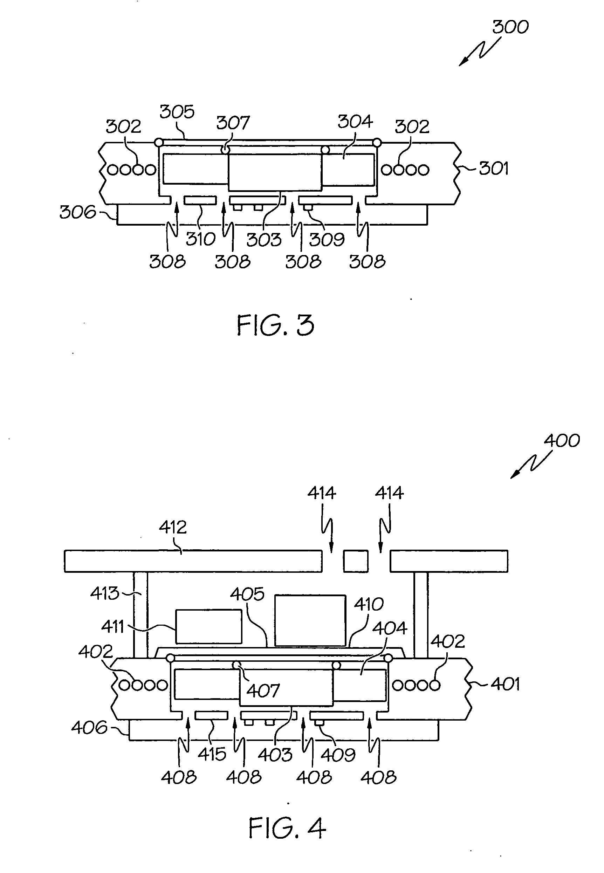

Figure 3 shows a diagram of a speaker system according to another embodiment of the present invention. In this embodiment, the speaker system 300 includes a printed circuit board 301 and a speaker assembly that includes a coil 302, a magnet 303, one or more magnet holder devices 304, a diaphragm 305, and one or more attachment devices 307 for attaching the magnet holders 304 to the diaphragm 305. In this example embodiment, the printed circuit board 301 may have the ability to support one or more electronic components 309 on a portion 310 of the printed circuit board 301 located on an opposite side of the printed circuit board 301 supporting the diaphragm 305. An optional shield can 306 is also shown. The portion of the circuit board 310 that supports the electronic components 309 may include ports 308 that allow sound generated by the speaker assembly to escape. Although not shown, ports for allowing the sound to escape may also be included in the shield can 306. In this embodiment, the speaker assembly is embedded at least partially in the printed circuit board 301; however, a portion 310 of the printed circuit board 301 still has the capability of supporting one or more electronic components 309.

Figure 4 shows a diagram of a speaker system according to a still further embodiment of the present invention. The speaker system 400 includes a printed circuit board 401 with an at least partially embedded speaker assembly that includes a coil 402 embedded in the printed circuit board 401, a magnet 403, one or more magnet holders 404, a diaphragm 405, and one or more attachment devices 407 used to attach the magnet 403 to the diaphragm 405. Optionally, a shield can 406 may also be included in the speaker assembly. In this example embodiment, a flexible film 410 that contains printed circuits may be attached to the printed circuit board 401 above the diaphragm 405 via an attachment structure. This flexible film 410 allows the attachment of one or more electronic components 411 to the flexible film. This provides additional capacity for adding electronic components above the speaker assembly. In embodiments according to the present invention, the flexible film 410 may be a flexible circuit board having electrical traces and pads for mounting and interconnecting electronic integrated circuits and other electronic devices.

The flexible film 410, with the ability to add additional components, is shown in this embodiment along with a portion 415 of the printed circuit board 401 that also may support the addition of electronic components (as noted previously). The portion 415 of the printed circuit board 401 may be located on the opposite side of the printed circuit board 401 from the side with the flexible film 410 and the diaphragm 405. The portion 415 of the printed circuit board 401, as noted in the discussion of Figure 3, may also support the addition of additional components 409 being attachable to the printed circuit board portion 415. The portion 415 of the printed circuit board 401 need not be included in this example embodiment that includes the flexible film 410, but is merely shown here to illustrate that additional components may be attached to both a top surface and a bottom surface of a printed circuit board containing an embedded speaker assembly. As noted previously, ports may be included into the printed circuit board portion 415 supporting the components 409 to allow sound to escape from the speaker assembly. Ports (not shown) may also be included in the shield can 406. For illustrative purposes, this embodiment is shown as being included in a mobile phone where a phone cover 412 is shown along with one or more attachment devices 413 for supporting the phone cover 412 on the printed circuit board 401. The phone cover 412 may include ports 414 for allowing sound to escape to an ear of a user of the mobile phone.

Although the present invention has been illustrated with embodiments where the coil 102 is embedded in the PCB 101 and the magnet 103 is located in a through hole or a cavity of the PCB 101, other examples not falling within the scope of the present invention may provide varying degrees of compactness of the speaker relative to the PCB. In an example, the coil 102 may be located on a surface of the PCB 101 and the magnet 103 located in a cavity or hole in the PCB in alignment with the coil. While this does not maximize the compactness of the speaker, it does recess the magnet in the PCB.

Although embodiments of the present invention have been shown with the diaphragm 105 and shield can 106 as possible separate items that may also be attached to the PCB 101, other embodiments according to the present invention may include either one or both the diaphragm and shield being integrally formed with the PCB 101 or embedded as part of the PCB 101 during its manufacture.

Further, in addition to providing speaker systems embedded in PCBs, embodiments of the present invention also includes methods of manufacturing such items. A PCB 101 is provided or formed having a coil 102 embedded in the PCB. The PCB 101 further includes either a hole or cavity sized to receive a magnet 103. Either integrally formed as part of the PCB or placed in the hole or cavity may be one or more supports 104, with the magnet being connected to the supports. A diaphragm 105 may be placed over the cavity or hole in the PCB. The diaphragm may either be connected to the PCB 101, supports 104, or both. In some embodiments, a shield can 106 may be attached to the PCB on a side opposite that of the diaphragm. In some embodiments, ports 308 may be provided in either surface of the PCB adjacent to the magnet or the shield can, if one is present.

The terminology used herein is for the purpose of describing particular embodiments only and is not intended to be limiting of the invention.

## Claims

1. A speaker system (400) comprising:
a printed circuit board, PCB, (401), the PCB (401) including one of a cavity or through hole; and
a speaker assembly (402, 403, 404, 405), the speaker assembly (402, 403, 404, 405) comprising at least a magnet (403) and a coil (402),
wherein at least the magnet (403) is at least partially located in the cavity or through hole of the PCB (401) and wherein the coil (402) of the speaker assembly (402, 403, 404, 405) is embedded in the PCB (401).

2. The speaker system (400) according to claim 1, wherein the coil (402) embedded in the PCB (401) is useable as a T-coil.

3. The speaker system (400) according to claim 1, the PCB (401) further comprising the capability of mounting electronic components (409) on a portion (415) of the PCB (401) parallel to the speaker assembly (402, 403, 404, 405) and on a side of the speaker assembly (402, 403, 404, 405) opposite a diaphragm (405) of the speaker assembly (402, 403, 404, 405).

4. The speaker system (400) according to claim 1, the PCB (401) further comprising the capability of mounting electronic components on a flexible tape (410) attached to the PCB (401) parallel to the speaker assembly (402, 403, 404, 405) and on a side of the speaker assembly (402, 403, 404, 405) above a diaphragm (405) of the speaker assembly (402, 403, 404, 405).

5. The speaker system (400) according to claim 1, wherein the speaker assembly is at least partially embedded in the cavity or through hole of the PCB (401), and
wherein the speaker assembly (402, 403, 405) further comprises a diaphragm (405), the diaphragm (405) being attached to at least one of the PCB (401), the magnet (403), or at least one support associated with the magnet.

6. The speaker system (400) according to claim 5, further comprising a shield can (406) attached to a surface of the PCB (401).

7. The speaker system (400) according to claim 5, wherein the coil (402) embedded in the PCB (401) is useable as a T-coil.

8. The speaker system (400) according to claim 5, the PCB (401) further comprising the capability of mounting electronic components (409) on a portion of the PCB (401) parallel to the speaker assembly (402, 403, 405) and on a side of the speaker assembly (402, 403, 405) opposite a diaphragm (405) of the speaker assembly(402, 403, 405).

9. The speaker system (400) according to claim 5, the PCB (400) further comprising the capability of mounting electronic components (411) on a flexible tape (410) attached to the PCB (401) parallel to the speaker assembly (402, 403, 405) and on a side of the speaker assembly (402, 403, 405) above a diaphragm (405) of the speaker assembly (402, 403, 405).

10. An electronic device comprising a speaker system according to claims 1-9, wherein the electronic device is one of a mobile phone, a personal digital assistant, a computer, an electronic game device, an electronic audio device, or an electronic video device.

## Patentansprüche

1. Ein Lautsprechersystem (400), umfassend:
eine gedruckte Schaltungsplatine , PCB, (401), wobei die PCB (401) eines von einer Kavität oder einem Loch enthält; und
eine Lautsprecheranordnung (402, 403, 404, 405), wobei die Lautsprecheranordnung (402, 403, 404, 405) mindestens einen Magnet (403) und eine Spule (402) umfasst,
wobei mindestens der Magnet (403) mindestens teilweise sich in der Kavität oder dem Loch der PCB (401) befindet, und wobei die Spule (402) der Lautsprecheranordnung (402, 403, 404, 405) eingebettet ist in der PCB (401).

2. Das Lautsprechersystem (400) nach Anspruch 1, wobei die Spule (402), eingebettet in die PCB (401), verwendbar ist als eine T-Spule.

3. Das Lautsprechersystem (400) nach Anspruch 1, wobei die PCB (401) ferner die Fähigkeit eines Anbringens elektronischer Komponenten (409) an einem Teil (415) der PCB (401) parallel zu der Lautsprecheranordnung (402, 403, 404, 405) und einer Seite der Lautsprecheranordnung (402, 403, 404, 405) entgegengesetzt einer Membran (405) der Lautsprecheranordnung (402, 403, 404, 405) umfasst.

4. Das Lautsprechersystem (400) nach Anspruch 1, wobei die PCB (401) ferner die Fähigkeit eines Anbringens elektronischer Komponenten auf einem flexiblen Band (410), angebracht an der PCB (401), parallel zu der Lautsprecheranordnung (402, 403, 404, 405) und auf einer Seite der Lautsprecheranordnung (402, 403, 404, 405) über einer Membran (405) der Lautsprecheranordnung (402, 403, 404, 405) umfasst.

5. Das Lautsprechersystem (400) nach Anspruch 1, wobei die Lautsprecheranordnung mindestens teilweise eingebettet ist in der Kavität oder dem Loch der PCB (401), und
wobei die Lautsprecheranordnung (402, 403, 405) ferner eine Membran (405) umfasst, wobei die Membran (405) angebracht ist an mindestens einem von der PCB (401), dem Magnet (403) oder mindestens einer Stützung in Zusammenhang stehend mit dem Magnet.

6. Das Lautsprechersystem (400) nach Anspruch 5, ferner umfassend eine Abschirmung (406), angebracht an einer Oberfläche der PCB (401).

7. Das Lautsprechersystem (400) nach Anspruch 5, wobei die Spule (402), eingebettet in der Platine (401), verwendbar ist als eine T-Spule.

8. Das Lautsprechersystem (400) nach Anspruch 5, wobei die PCB (401) ferner die Fähigkeit eines Anbringens elektronischer Komponenten (409) auf einem Teil der PCB (401) parallel zu der Lautsprecheranordnung (402, 403, 405) und einer Seite der Lautsprecheranordnung (402, 403, 405), entgegengesetzt einer Membran (405) der Lautsprecheranordnung (402, 403, 405) umfasst.

9. Das Lautsprechersystem (400) nach Anspruch 5, wobei die PCB (400) ferner die Fähigkeit eines Anbringens elektronischer Komponenten (411) auf einem flexiblen Band (410), angebracht auf der PCB (401), parallel zu der Lautsprecheranordnung (402, 403, 405) und auf einer Seite der Lautsprecheranordnung (402, 403, 405) über einer Membran (405) der Lautsprecheranordnung (402, 403, 405) umfasst.

10. Ein elektronisches Gerät, umfassend ein Lautsprechersystem nach Ansprüchen 1 - 9, wobei das elektronische Gerät eines ist von einem Mobiltelefon, einem persönlichen digitalen Assistenten, einem Computer, einem elektronischen Spielegerät, einem elektronischen Audiogerät oder einem elektronischen Videogerät.

## Revendications

1. Enceinte acoustique (400) comprenant :
une carte de circuit imprimé, dite PCB, (401), la PCB (401) comportant l'un(e) d'une cavité ou d'un trou traversant ; et
un ensemble de haut-parleurs (402, 403, 404, 405), l'ensemble de haut-parleurs (402, 403, 404, 405) comprenant au moins un aimant (403) et une bobine (402),
dans laquelle au moins l'aimant (403) est au moins partiellement situé dans la cavité ou dans le trou traversant de la PCB (401) et dans laquelle la bobine (402) de l'ensemble de haut-parleurs (402, 403, 404, 405) est intégrée dans la PCB (401).

2. Enceinte acoustique (400) selon la revendication 1, dans laquelle la bobine (402) intégrée dans la PCB (401) est utilisable en tant que bobine en T.

3. Enceinte acoustique (400) selon la revendication 1, la PCB (401) comprenant en outre la capacité de monter des composants électroniques (409) sur une partie (415) de la PCB (401) parallèle à l'ensemble de haut-parleurs (402, 403, 404, 405) et sur un côté de l'ensemble de haut-parleurs (402, 403, 404, 405) opposé à un diaphragme (405) de l'ensemble de haut-parleurs (402, 403, 404, 405).

4. Enceinte acoustique (400) selon la revendication 1, la PCB (401) comprenant en outre la capacité de monter des composants électroniques sur une bande souple (410) fixée à la PCB (401) parallèle à l'ensemble de haut-parleurs (402, 403, 404, 405) et sur un côté de l'ensemble de haut-parleurs (402, 403, 404, 405) au-dessus d'un diaphragme (405) de l'ensemble de haut-parleurs (402, 403, 404, 405).

5. Enceinte acoustique (400) selon la revendication 1, dans laquelle l'ensemble de haut-parleurs est au moins partiellement intégré dans la cavité ou dans le trou traversant de la PCB (401), et
dans laquelle l'ensemble de haut-parleurs (402, 403, 405) comprend en outre un diaphragme (405), le diaphragme (405) étant fixé à au moins l'un de la PCB (401), de l'aimant (403) ou à au moins un support associé à l'aimant.

6. Enceinte acoustique (400) selon la revendication 5, comprenant en outre un boîtier de blindage (406) fixé à une surface de la PCB (401).

7. Enceinte acoustique (400) selon la revendication 5, dans laquelle la bobine (402) intégrée dans la PCB (401) est utilisable en tant que bobine en T.

8. Enceinte acoustique (400) selon la revendication 5, la PCB (401) comprenant en outre la capacité de monter des composants électroniques (409) sur une partie de la PCB (401) parallèle à l'ensemble de haut-parleurs (402, 403, 405) et sur un côté de l'ensemble de haut-parleurs (402, 403, 405) opposé à un diaphragme (405) de l'ensemble de haut-parleurs (402, 403, 405).

9. Enceinte acoustique (400) selon la revendication 5, la PCB (401) comprenant en outre la capacité de monter des composants électroniques (411) sur une bande souple (410) fixée à la PCB (401) parallèle à l'ensemble de haut-parleurs (402, 403, 405) et sur un côté de l'ensemble de haut-parleurs (402, 403, 405) au-dessus d'un diaphragme (405) de l'ensemble de haut-parleurs (402, 403, 405).

10. Dispositif électronique comprenant une enceinte acoustique selon les revendications 1 à 9, dans lequel le dispositif électronique est l'un d'un téléphone mobile, d'un assistant numérique personnel, d'un ordinateur, d'un dispositif de jeu électronique, d'un dispositif audio électronique ou d'un dispositif vidéo électronique.
